Europäisches Patentamt

European Patent Office

Office européen des brevets

(11) Publication number: **0 623 980 A2**

# EUROPEAN PATENT APPLICATION

(21) Application number: **94106986.6**

(22) Date of filing: **04.05.94**

(51) Int. Cl.⁵: **H01S 3/085**, H01S 3/025, G02B 6/42, G02B 6/34

(30) Priority: **06.05.93 IT TO930310**

(43) Date of publication of application:
**09.11.94 Bulletin 94/45**

(84) Designated Contracting States:
**DE FR GB IT NL SE**

(71) Applicant: **CSELT Centro Studi e Laboratori Telecomunicazioni S.p.A.**
**Via Guglielmo Reiss Romoli, 274**
**I-10148 Turin (IT)**

(72) Inventor: **Ghergia, Vittorio**
**Via Bovio 3**
**Torino (IT)**
Inventor: **Melindo, Flavio**
**Via Valgioie, 71**
**Torino (IT)**

(74) Representative: **Riederer Freiherr von Paar zu Schönau, Anton et al**
**Van der Werth, Lederer & Riederer**
**Postfach 2664**
**D-84010 Landshut (DE)**

(54) Semiconductor laser with transverse emission, and coupling thereof to an optical waveguide.

(57) A semiconductor laser (21) has, on the surface of a layer (25) adjacent to the active layer (24), a grating (29) with such a period as to reflect light in a direction transverse to the active layer (24); in this way light is emitted from a face parallel to the layer. The laser can be coupled to an optical waveguide (11) realized in a substrate (12) on which the laser (21) can be fixed and which is provided with a grating (13) capable of rotating the radiation emitted by the laser (21) by the angle necessary for transferring the radiation into the waveguide.

Fig. 4

The present invention relates to components for optical communication systems, and more particularly it concerns a semiconductor laser with emission in a direction transverse to the active region plane, and its coupling to an optical waveguide.

Optical communication systems often need insertion of a laser into a optical interconnection circuit, by coupling it to an optical waveguide.

One of the main problems arising when realizing this coupling, in the case of conventional lasers with longitudinal emission, is the criticity of the geometrical tolerances necessary to correctly position the laser emission region with respect to the waveguide input, due to the very small dimensions of the involved areas. For this reason, an indirect coupling is in general adopted, through fiber tails respectively fixed to the laser and to the waveguide and possibly connected through a suitable connector. This operation is long, difficult and therefore expensive; furthermore it can be performed only by skilled workers.

A simpler and more rapid technique is already used for detectors: according to this technique the optical waveguide is associated to a minor-like element reflecting the radiation towards the sensitive region of the detector, which is fixed above the waveguide. In the case of the detector the positioning problem is actually less critical as the sensitive region of a detector is quite large.

The application of this technique to the case of lasers requires the use of lasers emitting in vertical direction (perpendicular to the active region plane). Lasers with vertical emission are well known in the art and an example is described in US-A-463 3476: that laser is provided, in correspondence of the active layer, with reflecting grooves having walls inclined by such an angle that light is emitted in a vertical direction. In this kind of structure, the emission region has very small dimensions and therefore, should the structure be coupled to the waveguide through a mirror, the problem would arise of correctly positioning the laser emission region with respect to the mirror which transfers the light emitted by the laser to the waveguide.

It is an object of the present invention to provide a laser of this type, having a large emission region, allowing a easy coupling to an optical waveguide, in a cheap manner and by employing non-skilled workers.

The laser according to the invention comprises a grating, on the surface of a layer adjacent to the active layer, with such a period as to reflect light in a direction transverse to the active layer, so that light is emitted through one of the laser faces parallel to the active layer.

The laser can be a Fabry-Perot laser with totally reflecting mirrors on the facets of the cavity, and the grating is realized inside the cavity itself.

In another embodiment, the laser is a distributed feedback laser, and the grating is realized in the same layer as the grating or the gratings providing the feedback, in an area external to the cavity and located on the path of the light coming out from the same.

Another object of the present invention is to provide an optical device including a semiconductor laser with transverse emission coupled to an optical waveguide, where:

- the laser includes, on the surface of a layer adjacent to the active layer, a grating with such a period as to reflect light in a direction transverse to the active layer, so that light is emitted through one of the laser faces parallel to the active layer, said face being associated with elements for fixing the laser above a substrate where the optical waveguide is realized; and
- the optical waveguide includes, in an area intended to face the laser emission region, a grating, corresponding to the laser grating, for transferring the light emitted by the laser into the waveguide.

The elements for fixing the laser to the waveguide substrate are preferably of the type allowing a self-aligning soldering, e.g. solder microbumps like those used for integrated circuits soldering. The use of these elements, together with the fact that the laser emission area is quite large, makes uncritical the relative positioning of the laser and waveguide when carrying out the coupling. Related operations can be therefore executed rapidly and without employing skilled workers.

The present invention will be made clearer with reference to the annexed drawings, wherein:

- Figure 1 is a schematic sectional view showing a first embodiment of a laser in accord with the present invention;
- Figure 2 is a simplified sectional view of the laser of Figure 1 coupled to a optical waveguide;
- Figure 3 is a plan view of the waveguide; and
- Figure 4 is a schematic sectional view showing a second embodiment of the laser in accordance with the present invention, coupled to the optical waveguide.

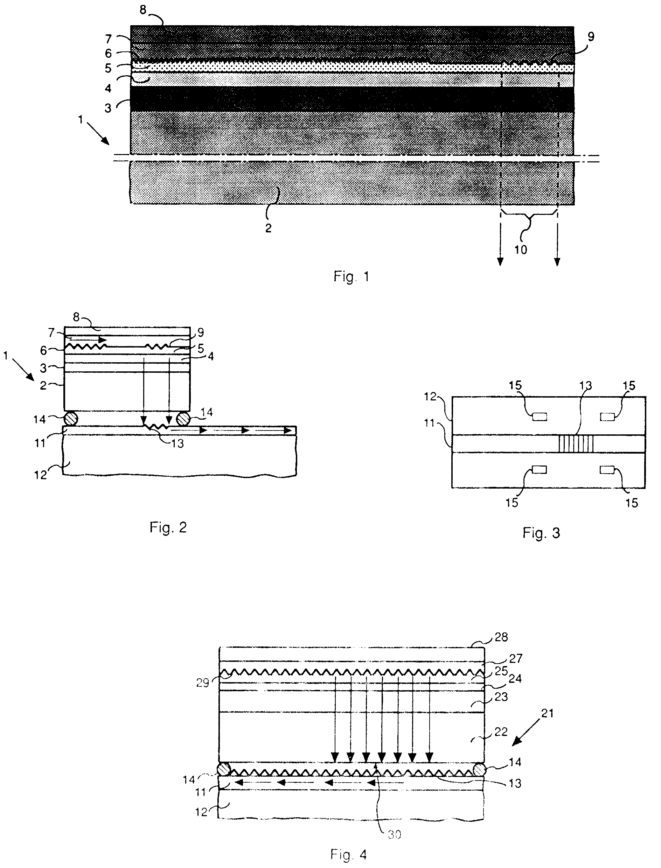

As shown in Figure 1, a distributed feedback laser 1 according to the invention conventionally includes: a substrate 2 of a first semiconductor, e.g. InP, having a doping of a first type, e.g. of n type; a buffer layer 3, also of InP with n doping; an active layer 4, e.g. of quaternary alloy InGaAsP; a coating layer 5, also of a quaternary alloy InGaAsP, but with a different composition from the active layer, and comprising a grating 6 providing optical feedback and having period 1 which causes back reflection of the light emitted from the active layer; a layer 7 of InP with a p type doping; a cover layer 8, e.g. of an InGaAs alloy. The means for connecting the laser to an electric power source have not been represented for drawing simplicity reasons.

Grating 6 is realized only over a certain portion of layer 5, corresponding to the laser cavity. The remaining part is provided with a second grating 9, separated from grating 6 and with period Λ2 different from Λ1 and such as to cause downwards reflection of the radiation, in a perpendicular direction to the plane of the active layer 5, as shown in the drawing, or in an inclined direction. In this way a quite large emission region 10, which substantially corresponds to the length of grating 9, is obtained. Determination of $\lambda_2$ so as to obtain transverse emission is not a problem for the skilled in the art, taking into account relation:

$$\Lambda = \frac{\lambda \cdot m}{2n_{eff}} \, (1+\sin\varphi) \qquad\qquad (1)$$

where Λ is the grating period. $\lambda$ is the wavelength, m is the grating order, $n_{eff}$ is the effective refractive index $\phi$ is the light emission angle with respect to the vertical direction. Note that relation (1) with $\phi$ = 90° just gives the Bragg condition for which back-reflection is obtained.

Figure 2 shows an optical device obtained by coupling laser 1 to an optical waveguide 11, more particularly a strip optical waveguide in glass or silica realized on a silicon wafer 12. In this device, laser 1 overlaps wafer 12, so that its emission area 10 is in register with a grating 13, realized in the waveguide 11 and having such a period as to reflect in a horizontal direction and to transfer into waveguide 11 the radiation emitted by laser 1. The laser can be fixed to wafer 12 through beads or microbumps 14 of alloys for self-aligning soldering, e.g. of the so called "flip-chip" type, applied on the laser emitting face and becoming jointed to pads 15 (Figure 3) realized on the wafer around the area of grating 13. These alloys for self-aligning soldering, which are in general In, Pb and/or Ag alloys, are well known in the semiconductor technique, where they are often used for integrated circuit connection. Pads 15 may for instance be made of layers of Au and Sn, which on melting, result in an Au/Sn alloy. Also these materials are conventionally used in the art.

For manufacturing the above described device, laser 1 and waveguide 11 are produced with any conventional technique. Grating 9 is realized during laser manufacturing, in the same work step in which distributed feedback grating 6 is obtained (e.g. through holographic techniques or electron beam lithography). Similar techniques can be used for realizing grating 13 of waveguide 11. Once laser 1 and waveguide 11 with grating 13 are realized, soldering beads 14 will be applied to the laser ad fusion thereof on pads 15 of wafer 12 will be obtained.

Self-aligning soldering by the above technique can be performed also by non-skilled workers. Moreover, when mounting laser 1 on wafer 12 an accurate check of the mutual position of emission region 10 and grating 13 is not necessary, because the correct positioning is ensured by the self-aligning soldering. Coupling operations are therefore more rapid. Finally, the quite large dimensions of emission region 10 and grating 13 and the width of the optical waveguide grating, which can be approximately 5 times greater than the width of the laser grating, make less critical the mutual positioning.

Figure 4 shows the application of the present invention in the case of a Fabry-Perot laser, indicated in its whole by 21. References 22-25, 27, 28 are indicated the layers corresponding to layers 2-5, 7-8 in Figure 1. In this laser the cavity is delimited by two mirrors provided in correspondence with the laser end facets; said mirrors instead of being partially reflecting, as in the case of conventional Fabry-Perot lasers, are made totally reflecting so that the radiation cannot be longitudinally emitted; e.g. the internal faces of the two mirrors are metalized. Coating layer 25 is provided with grating 29, parallel to active layer 24 and preferably having a low coupling. Grating 29 is provided along the whole laser cavity and has such a period as to provoke downward reflection of the radiation, perpendicularly to active layer 24. Thus, emission region 30 has substantially the same length as the cavity.

Laser 21 is then fixed above waveguide 11 through self-aligning soldering beads 14, as shown in Figure 2. The waveguide grating, indicated again with 13, will have also in this case a period capable of provoking reflection in a horizontal direction and the transfer of the radiation emitted by the laser into waveguide 11.

It is clear that what described has been given only by way of non limiting example, and that variations and modifications are possible without going out of the scope of the invention. Laser 1, for example, can be realized with GaAs/GaAlAs compounds, or it can be a distributed Bragg reflector laser; the optical waveguide can be a semiconductor optical waveguide; reflection can take place in an inclined direction, and not perpendicularly, etc.

**Claims**

1. A semiconductor laser, including a plurality of superimposed layers of semiconductor material, one of which at least is an active layer (4; 24) which emits light and is associated to optical feedback means (6; 26) which form a laser cavity, characterized in that it also includes, on the surface of a layer (5; 25) adjacent to the active layer (4; 24), a grating (9; 29) with such a period as to reflect light in a direction transverse to the active layer (4; 24), in order that light is emitted through one of the laser faces (10; 30) parallel to the active layer (4; 24).

2. A laser according to claim 1, characterized in that the laser (21) is a Fabry-Perot laser in which the internal surface of the mirrors defining the cavity is totally reflecting, and the grating (29) reflecting light in a direction transverse to the active layer (24) extends inside and along the whole cavity.

3. A laser according to claim 2, characterized in that the grating (29) is a low coupling grating.

4. A laser according to claim 1, characterized in that the laser (1) is a distributed feedback laser and the grating (9) provoking transverse reflection is realized in the same layer (5) where distributed feedback grating or gratings (6) are provided, in an area external to the cavity and located on the path of the light coming out from the same.

5. An optical device including: a semiconductor laser (1; 21) with transverse emission according to any of the preceding claims, coupled to an optical waveguide (11) realized in a substrate (12) on which the laser (1; 21) can be fixed.

6. A device according to claim 5, characterized in that the optical waveguide (11) has, in an area intended to face the laser emission region (10; 30), a grating (13), with a period capable of rotating the radiation emitted by the laser (1; 21) by the angle necessary for transferring such radiation into the waveguide.

7. A device according to claims 5 or 6, characterized in that the laser is associated, on the face through which emission occurs, to means (14) for self-aligning soldering on pads (15) realized on the substrate (12) of the waveguide (11).

8. A method for coupling a semiconductor laser to an optical waveguide, characterized in that it comprises the steps of: realizing in said laser (1; 21), on the surface of a layer (5; 25) adjacent to an active layer (4; 24) emitting the light radiation, a first grating (9; 29) with a period such as to provoke radiation reflection in a direction transverse to the plane of the active layer (4; 24), so that the radiation is emitted through one of the faces of the laser (1; 21) parallel to the active layer (4; 24); realizing in the optical waveguide (11) a second grating (13) with a period such that said second grating (13) is capable of rotating the radiation emitted by the laser (1; 21) by the angle necessary for transferring the radiation into the waveguide; and fixing the laser (1; 21) on a substrate (12) where the waveguide (11) is realized, so that the laser emission region (10; 30) faces the second grating (13).

9. A method according to claim 8, in which the laser (21) is a Fabry-Perot laser, characterized in that the cavity end facets are made completely reflecting and the first grating (29) is realized inside the cavity.

10. A method according to claim 8, in which the laser (1) is a distributed feedback laser, characterized in that the first grating (9) is realized outside the cavity and on the path of the light coming out from same, in the same layer (5) where the grating or gratings (6) for optical feedback are realized.

11. A method according to any of claims 8 to 10, characterized in that fixing of the laser (1) to the substrate (12) is obtained through self-aligning soldering beads (14), which are fused on pads (15) realized on the substrate (12).

Fig. 1

Fig. 2

Fig. 3

Fig. 4